# EUROPÄISCHE PATENTSCHRIFT

(11) **EP 3 545 564 B1**
(45) Veröffentlichungstag und Bekanntmachung des Hinweises auf die Patenterteilung: **30.12.2020**
(21) Anmeldenummer: 17805157.9
(22) Anmeldetag: 21.11.2017
(51) Int. Cl.: H01L 41/047, H01L 41/053, H01L 41/08, H01L 41/083

(54) **VORRICHTUNG, DIE EINEN HAPTISCHEN FEEDBACK VERMITTELT UND BAUELEMENT MIT DER VORRICHTUNG**
DEVICE THAT PROVIDES A HAPTIC FEEDBACK AND COMPONENT WITH THE DEVICE
DISPOSITIF DONNANT UNE RÉTROACTION HAPTIQUE ET ÉLÉMENT DE CONSTRUCTION AVEC LE DISPOSITIF

(30) Priorität: 23.11.2016 DE 102016122610
(43) Veröffentlichungstag der Anmeldung: 02.10.2019
(73) Patentinhaber: TDK Electronics AG, 81671 München (DE)
(72) Erfinder: KASTL, Harald, 8524 Bad Gams (AT); GALLER, Martin, verstorben (AT)
(74) Vertreter: Epping - Hermann - Fischer
(86) Internationale Anmeldenummer: PCT/EP2017/079898
(87) Internationale Veröffentlichungsnummer: WO 2018/095900

(56) Entgegenhaltungen:
- CN-U- 204 167 367
- US-A- 5 729 077
- US-A1- 2011 127 881
- US-B1- 6 798 888

## Beschreibung

Die vorliegende Erfindung betrifft ein Bauelement und eine Vorrichtung zur Erzeugung eines aktiven haptischen Feedbacks. Es handelt sich dabei um eine Vorrichtung, die dazu ausgestaltet ist, eine Rückmeldung an einen Nutzer zu erzeugen, wenn dieser eine Kraft auf das Bauelement ausübt. Ein solches Bauelement kann beispielsweise in einem Knopf, z.B. in einem Betätigungsknopf für Instrumente, eingesetzt werden. Das Bauelement kann das aktive haptische Feedback beispielsweise dazu erzeugen, um einem Nutzer mitzuteilen, dass von ihm vorgenommene Einstellungen erfolgreich von dem Bauelement umgesetzt werden.

Umgekehrt Können auch Bauelemente aktives haptisches Feedback geben, beispielsweise können Mobiltelefone Vibrationsalarme erzeugen. Es sind auch taktile Displays für mobile elektronische Geräte wie Notebooks etc. bekannt. Das haptische Feedback kann auch die Stärke von Kräften oder die Beschaffenheit von Oberflächen oder die Steifheit oder Elastizität von Materialien in eine taktil wahrnehmbare Empfindung umsetzen.

Aus der US 6 798 888 B1 ist eine Anordnung piezoelektrischer Wandler für sonare Anwendungen bekannt.

Aus der US 2011/127881A1 ist eine Anordnung piezoelektrischer Wandler bekannt, mit deren Hilfe Energie aus einer mechanischen Krafteinwirkung gewonnen werden kann.

Aus der CN 204 167 367 U ist es bekannt, zur Gewinnung von Energie piezoelektrische Wandler unter einer Fahrbahndecke anzuordnen. Das Dokumente US5729077 offenbart ebenso einen Aktor/Sensor Betrieb, eine Innenelektrode und eine Stapelung.

Aufgabe der vorliegenden Erfindung ist es, eine verbesserte Vorrichtung zur Erzeugung eines aktiven haptischen Feedbacks anzugeben.

Diese Aufgabe wird durch eine Vorrichtung gemäß dem vorliegenden Anspruch 1 gelöst. Vorteilhafte Ausgestaltungen der Erfindung gehen aus weiteren Ansprüchen hervor.

Es wird eine Vorrichtung zur Erzeugung eines aktiven haptischen Feedbacks angegeben. Diese umfasst einen piezoelektrischen Aktor zur Erzeugung eines Feedbacks in Form einer wahrnehmbaren Auslenkung. Der Aktor umfasst einen flachen piezoelektrischen Grundkörper mit annähernd planparallelen Hauptoberflächen. Im Grundkörper sind erste und zweite Aktorelektroden vorgesehen, über die eine piezoelektrische Auslenkung des piezoelektrischen Aktors bewirkt werden kann.

Der Grundkörper ist weiterhin so ausgestaltet, dass er ein haptisches Feedback erzeugt, wenn eine auf den Grundkörper ausgeübte Kraft erkannt wird. Zur Erzeugung des haptischen Feedbacks wird dann zwischen den ersten und zweiten Aktorelektroden eine elektrische Aktorspannung angelegt, die die piezoelektrische Auslenkung bewirkt und zu einer Längenänderung des Grundkörpers führt.

Die Vorrichtung erzeugt ein haptisches Feedback, wenn eine auf den Grundkörper beziehungsweise die Vorrichtung ausgeübte Kraft erkannt wird. Das Erkennen kann mit Hilfe des inversen piezoelektrischen Effekts erfolgen. Die auf den Grundkörper mit den Aktorelektroden ausgeübte Kraft erzeugt eine Ladungsverschiebung, die an Elektroden als Messspannung abgegriffen werden kann. Dazu können prinzipiell die Aktorelektroden verwendet werden.

Möglich ist es jedoch auch, zumindest eine separate Messelektrode im Grundkörper anzuordnen, und mit dieser Messelektrode die Messspannung zu erfassen, die aufgrund des inversen piezoelektrischen Effekts durch die ausgeübte Kraft erzeugt wird. Da die Messspannung mit zunehmender ausgeübter Kraft ansteigt, kann für die zu erfassende Messspannung ein Schwellwert definiert werden, der der gewünschten Auslösekraft zugeordnet ist. Erreicht die ausgeübte Kraft die Auslösekraft und übersteigt die Messspannung dabei den Schwellwert, so erkennt dies eine Messeinheit, die mit den Messelektroden verbunden ist. Beim Erreichen der Auslösekraft wird dann über einen Spannungsgenerator eine Aktorspannung erzeugt und an die Aktorelektroden angelegt. Gleichzeitig wird eine weitere Aktion ausgelöst, die zum Betrieb der Vorrichtung oder eines damit verbundenen elektrischen Bauelements dient.

Um die Aktorwirkung besser wahrzunehmen, erfolgt insbesondere die Längenänderung des Grundkörpers bevorzugt parallel zur ausgeübten Kraft, also entlang einer Normalen zu einer Hauptoberfläche des Aktors. Möglich ist es auch, eine Längenänderung in dazu senkrechter Richtung durch geeignete geometrische Maßnahmen in der Vorrichtung umzulenken.

Der piezoelektrische Grundkörper ist also zum Einen Teil des piezoelektrischen Aktors, dessen Aktorwirkung eine piezoelektrische Auslenkung ist. Weiterhin kann darüber hinaus über die piezoelektrischen Eigenschaften des Grundkörpers auch die auf diesen Grundkörper ausgeübte Kraft erkannt und in ein elektrisches Signal umgesetzt werden.

Das Feedback wird als aktives Feedback bezeichnet, da es von der Vorrichtung selbst erzeugt wird. Das Feedback wird als haptisches Feedback bezeichnet, da es ein Nutzer über seinen Tastsinn wahrnehmen kann.

Wird eine Spannung an die Aktorelektroden angelegt, so erzeugt der Grundkörper eine Längenausdehnung. Die Längenausdehnung kann senkrecht zur Normalen erfolgen, wobei die Normale senkrecht zur Hauptoberfläche des Grundkörpers steht. Eine solche Längenänderung wird auch als Querkontraktion bezeichnet. Die Richtung der Längenausdehnung ist dabei von der Polarität der angelegten Spannung und von der Polarisierung des piezoelektrischen Materials abhängig.

Da eine Querkontraktion für einen Nutzer, der eine Kraft parallel zur Normalen ausübt, schlecht wahrnehmbar ist, ist die Vorrichtung vorteilhaft dazu ausgestaltet, die Längenänderung des Grundkörpers von einer Richtung senkrecht zur Normalen in eine Längenausdehnung des Grundkörpers parallel zur Normalen umzuwandeln.

Die Umwandlung erfolgt dadurch, dass gemäß einer Ausführungsform auf beiden Hauptoberflächen des Grundkörpers ein kegelstumpfförmiges Blech befestigt ist, bei dem die stumpfen "Kegelspitzen" jeweils vom Grundkörper wegweisen. Das Blech ist dazu ausgestaltet, eine Längenausdehnung des Grundkörpers vertikal zur Normalen in eine Längenänderung parallel zur Normalen zu transformieren. Das Blech kann weiterhin dazu dienen, eine Längenänderung des Grundkörpers parallel zur Normalen, die infolge der Querkontraktion des Grundkörpers erfolgt, zu verstärken. Das kegelstumpfförmig gebogene beziehungsweise geformte Blech kann eine Querkontraktion aufnehmen und verformt sich dabei in die gewünschte Richtung, nämlich parallel zur Normalen. Diese Verformung kann dabei stärker ausfallen als die piezoelektrische Auslenkung in der gleichen Richtung. Mit dem kegelstumpfförmigen Blech auf beiden Hauptoberflächen des Grundkörpers wird daher eine gut wahrnehmbare Längenänderung der gesamten Vorrichtung bewirkt.

Damit das Blech unter Aktoreinwirkung elastisch merklich verformbar ist, kann es eine typische Dicke aufweisen, die z.B. bei Titan im Bereich zwischen 0,1 bis 0,4mm liegt

Der Grundkörper mit den beiden kegelstumpfförmigen Blechen ist vorteilhaft über seine Kegelstümpfe zwischen einer Basis und einem Betätigungsmittel fixiert. Das Betätigungsmittel wiederum steht mit der Basis in Verbindung und ist mittels einer Vorspannung fixiert, die als Zug- oder Druckspannung eingestellt ist und z.B. über Federn vermittelt wird.

In der einfachsten Ausführungsform ist das Betätigungsmittel als eine Betätigungsplatte ausgebildet, die parallel zur Oberfläche des Grundkörpers und damit parallel zur Basis ausgerichtet ist. Sie liegt auf der Deckfläche des oberen kegelstumpfförmigen Blechs auf und ist vorzugsweise relativ zur Basis frei beweglich. Die Betätigungsplatte steht über dem Grundkörper an zumindest zwei Seiten, besser an allen Seiten über und ist im überstehenden Bereich über Federn mit der Basis verbunden, wobei die Federn unter Vorspannung stehen. Auf diese Weise ist gewährleistet, dass ein auf die Betätigungsplatte einwirkender Druck, beispielsweise der Fingerdruck eines Nutzers, sicher aufgenommen wird und zumindest der parallel zur Normalen wirkende Kraftanteil auf den Grundkörper übertragen wird. Die Betätigungsplatte kann so ausgestaltet sein, dass sie bei nicht vertikal einwirkender Betätigung/Krafteinwirkung ein wenig abkippen kann, und dennoch die Kraft auf den Grundkörper überträgt. Die Federverspannung führt dazu, dass sich die Betätigungsplatte nach Auslenkung wieder parallel zur Basis beziehungsweise parallel zur Hauptoberfläche des Grundkörpers ausrichtet.

Alternativ ist das Betätigungsmittel als Membran ausgebildet, die so mit der Basis verbunden ist, dass sie eine in Richtung Basis wirkende Kraft oder Vorspannung auf den mit jeweils zwei kegelstumpfförmigen Blechen auf den Hauptoberflächen versehenen Grundkörper ausübt.

Wenn die Membran ausreichend elastisch ausgebildet ist, ist kann sie auch hervorragend eine Verformung aufnehmen, die durch Betätigung der Vorrichtung zur Erzeugung eines aktiven haptischen Feedbacks zwangsläufig erfolgt. Ebenso erlaubt es die Elastizität der Membran, dass sich die Vorrichtung wieder in die Ausgangsposition zurück verformt.

In einer alternativen Ausführung wird der Grundkörper über seine kegelstumpfförmigen Bleche zwischen der Basis und einem als Betätigungsplatte ausgebildeten Betätigungsmittel fixiert, wobei auf die Betätigungsplatte ein in Richtung Basis wirkender Federdruck ausgeübt wird. Dieser kann über Spiralfedern erzeugt werden, die sich an einem Bügel abstützen, der an der Basis befestigt und so angeordnet ist, das er mit einem Bügelende vertikal über dem Grundkörper steht. Der Bügel kann auch eine Schiene sein, die beispielsweise ein zweifach gebogenes Querschnittsprofil aufweist. Ein unteres flachen Teil kann auf der Basis befestigt sein, während das obere flache Teil über dem Grundkörper steht. Anstelle eines Bügels kann das Halteelement auch als Hülse mit einem übergebördelten Rand ausgebildet sein, wobei die Hülse dann gleichzeitig eine Führung für die Längenausdehnung der gesamten Vorrichtung darstellt. Die unter Druckspannung zwischen Hülse beziehungsweise Bügel und Betätigungsplatte stehenden Spiralfedern bewirken dabei eine sichere Halterung und eine Rückführung in einer Ausgangsposition nach Betätigung der Vorrichtung beziehungsweise nach Auslenkung des piezoelektrischen Aktors.

Das kegelstumpfförmige Blech weist einen Randbereich auf, der flach auf einer der Hauptoberflächen des Grundkörpers aufliegt und dort befestigt ist. Weiterhin weist der Kegelstumpf eine Mantelfläche auf, die in Richtung der Normalen über der jeweiligen Hauptoberfläche absteht. An der stumpfen Kegelspitze weist das Blech eine Deckfläche auf, die annähernd parallel zur Oberfläche des Grundkörpers ausgerichtet ist.

Das kegelstumpfförmige Blech weist daher vorzugsweise eine runde Grundfläche auf, mit deren Hilfe Längenänderungen parallel zur Hauptoberfläche unabhängig vom Winkel zum Grundkörper am besten aufgenommen und durch Verformung des Bleches in Richtung parallel zur Normalen verstärkt werden können.

Die Vorrichtung stellt also praktisch einen manuellen Schalter dar, dessen Auslösepunkt über den Schwellwert eingestellt werden kann. Gleichzeitig erzeugt der Schalter ein haptisches Feedback, an dem der Nutzer, der die Kraft beispielsweise mittels eines Fingerdrucks ausübt, das Erreichen der Auslösekraft und damit den Schaltvorgang erkennt. Möglich ist auch, mehrere Schwellwerte zu definieren und und mittels einer Steuerung unterschiedliches haptisches Feedback zu erzeugen, so dass unterschiedliche Auslösekräfte erkannt , in unterschiedliche Aktionen umgesetzt und über unterscheidbares Feedback an den Nutzer übermittelt werden können.

Als Messelektroden können wie gesagt die Aktorelektroden dienen. Als Messelektrode kann auch eine dritte Elektrode verwendet werden und die Messspannung zwischen der Messelektrode und einer Aktorelektrode abgegriffen werden. Möglich ist es jedoch auch, zwei separate Messelektroden im Grundkörper vorzusehen.

Die zumindest eine von den Aktorelektroden verschiedene Messelektrode kann mittig im Grundkörper zwischen ersten und zweiten Aktorelektroden angeordnet sein. Möglich ist es jedoch auch, die zumindest eine Messelektrode in der Nähe einer der beiden Hauptoberflächen anzuordnen, so dass alle anderen ersten und zweiten Aktorelektroden auf der gleichen Seite der Messelektrode im Grundkörper angeordnet sind.

Der Abstand zwischen den Messelektroden beziehungsweise zwischen den als Messelektroden verwendeten Elektroden, von denen zumindest eine eine Aktorelektrode sein kann, kann vorteilhaft größer gewählt werden als der Abstand zwischen den ausschließlich als erste und zweite Aktorelektroden verwendeten Elektroden. Ein größerer Abstand zwischen den Messelektroden, zwischen denen ja ebenefalls piezoelektrisches Material angeordnet ist, hat zur Folge, dass bei gleicher auf das zwischen den Messelektroden gebildete piezoelektrische Element einwirkender Kraft eine höhere Spannung erzeugt wird als zwischen den reinen Aktorelektroden. Eine höhere erzeugte Messspannung hat den Vorteil, dass ein geringerer Schwellwert für die Messspannung detektiert werden kann, der der Auslösekraft zugeordnet wird.

Eine erfindungsgemäße Vorrichtung benötigt zur Erzeugung einer wahrnehmbaren Auslenkung eine bestimmte Anzahl übereinander gestapelter Piezoelemente, beziehungsweise eine entsprechende Anzahl von ersten und zweiten Aktorelektroden, die alternierend angeordnet sind, so dass sich zwischen jeweils einer ersten und einer zweiten Aktorelektrode ein Piezoelement ausbildet. Über die Anzahl der Piezoelemente kann bei gleicher Gesamthöhe des Grundkörpers beziehungsweise bei gleicher Gesamtschichtdicke der einzelnen Piezoelemente die Aktorspannung eingestellt werden, die zum Erreichen einer bestimmten Längenausdehnung erforderlich ist. Eine große Schichtdicke zwischen zwei Aktorelektroden erfordert eine hohe Spannung zur Auslenkung. Viele kleine, gestapelte Piezoelemente erfordern eine geringere Spannung und erzeugen dennoch die gleiche Ausdehnung, wenn die Gesamthöhe der piezoelektrisch wirksamen Schichten übereinstimmt.

Erste und zweite Aktorelektroden sind vorzugsweise alternierend angeordnet und werden an unterschiedlichen Seiten des Grundkörpers nach außen hin einem Außenkontakt zugeführt. An die beiden Außenkontakte kann dann die Aktorspannung angelegt werden. In entsprechender Weise kann auch die zumindest eine Messelektrode mit einem Außenkontakt verbunden werden. Zum Erkennen der ausgeübten Kraft genügt jedoch ein einziges piezoelektrisches Element, zwischen dessen beiden Elektroden die Messspannung aufgrund des inversen piezoelektrischen Effekts entsteht.

Ein in der erfindungsgemäßen Vorrichtung verwendeter Grundkörper weist eine Abmessung in Richtung seiner Normalen auf, die relativ zur Abmessung vertikal dazu gering ist. Es handelt sich somit um einen flachen Grundkörper. Beispielsweise kann die maximale Ausdehnung des Grundkörpers in eine Richtung senkrecht zur Normalen mehr als zehn Mal so groß sein wie die in Richtung der Normalen gemessene Höhe des Grundkörpers. Die Länge des Grundkörpers kann die Höhe des Grundkörpers auch um den Faktor 20 und mehr übertreffen.

Die Längenausdehnung des Grundkörpers infolge des piezoelektrischen Effekts ist relativ gering und beträgt nur ca. 0,1 Prozent der gesamten piezoelektrisch wirksamen Höhe. Über die kegelstumpfförmigen Bleche wird das Ausmaß der Längenausdehnung in Richtung der Normalen verstärkt.

Die Gesamtausdehnung der erfindungsgemäßen Vorrichtung kann weiter verstärkt werden, wenn mehrere Vorrichtungen übereinander gestapelt werden. Es wird also eine Anzahl von zwei und mehr mit jeweils zwei kegelstumpfförmigen Blechen auf den Hauptoberflächen versehene Grundkörper übereinander gestapelt und vorzugsweise zwischen einem Betätigungsmittel und einer Basis fixiert. Dies kann zum Beispiel mittels Spiralfedern erfolgen, die eine Zug- oder Druckspannung ausüben und so das Betätigungsmittel und insbesondere die Betätigungsplatte in Richtung Basisplatte ziehen oder drücken.

Alternativ ist das Betätigungsmittel als Membran ausgebildet, die so mit der Basis verbunden ist, dass sie eine in Richtung Basis wirkende Kraft oder Vorspannung auf den oder die mit jeweils zwei kegelstumpfförmigen Blechen auf den Hauptoberflächen versehenen Grundkörper ausübt.

Bei mehreren übereinander gestapelten Grundkörpern ist die Betätigungsplatte besonders vorteilhaft, da sie gleichzeitig eine verbesserte Halterung für die Grundkörper darstellt und so ein seitliches Abkippen des Stapels verschiedener Grundkörper übereinander verhindert wird. Noch besser und vorteilhafter ist es jedoch, wenn die übereinander gestapelten Grundkörper in einer Art Hülse geführt werden, in der sich die Betätigungsplatte in Richtung der Normalen frei bewegen kann. Ein übergebördelter Rand der Hülse an der von der Basis entfernten Seite der Hülse kann gleichzeitig dazu dienen, zwischen dem Rand und der Betätigungsplatte eine unter Druckspannung stehende Feder einzuspannen. In der Hülse kann sich die Betätigungsplatte aber auch unter Vorspannung durch eine unter Zug stehende Spiralfeder bewegen. Der genannte überstehende obere Rand der Hülse kann als Anschlag für die Längenausdehnung parallel zur Normalen dienen.

Die erfindungsgemäße Vorrichtung kann als Betätigungsknopf ausgebildet sein, mit dem eine Funktion eines elektrischen Bauelements geschaltet werden kann. Der Schaltvorgang erfolgt dann beim Erreichen und dem Erkennen der definierten Auslösekraft, wobei der Schaltvorgang entweder direkt von der Messeinheit oder von einer daran angeschlossenen Steuereinheit vorgenommen wird. Die Steuereinheit kann auch den Spannungsgenerator umfassen.

Im Folgenden wird die Erfindung anhand von Ausführungsbeispielen und der dazugehörigen Figuren näher erläutert. Die Figuren sind dabei nur schematisch ausgeführt und nicht maßstabsgetreu. Einzelne Dimensionen können daher zur besseren Verständnis vergrößert oder verkleinert dargestellt sein.
Figur 1 zeigt einen als Aktor fungierenden Grundkörper im schematischen Querschnitt.
Figur 2 zeigt einen mit kegelstumpfförmigen Blechen versehenen Grundkörper.
Figur 3A zeigt einen Grundkörper, der zwischen einer Betätigungsplatte und der Basis mittels Zugfedern verspannt ist.
Figur 3B zeigt einen Grundkörper, der zwischen einer Betätigungsplatte und der Basis mittels Druckfedern verspannt ist.
Figur 4 zeigt eine räumliche Darstellung einer erfindungsgemäßen Vorrichtung in der Draufsicht.
Figur 5 zeigt Grundkörper mit Messeinheit und Generator.
Figuren 6A und 6B zeigen zwei verschiedene Anordnungen von Aktorelektroden und Messelektroden anhand eines schematischen Querschnitts durch den Grundkörper.
Figur 7 zeigt eine erfindungsgemäße Vorrichtung mit einem in Form eines durchgehenden Loches durchbrochenen Grundkörper.
Figur 8 zeigt eine erfindungsgemäße Vorrichtung, bei der mehrere Grundkörper übereinander gestapelt und fixiert sind.
Figur 9 zeigt eine erfindungsgemäße Vorrichtung mit einem Grundkörper, bei der über der oberen Zymbel eine Membran verspannt ist.

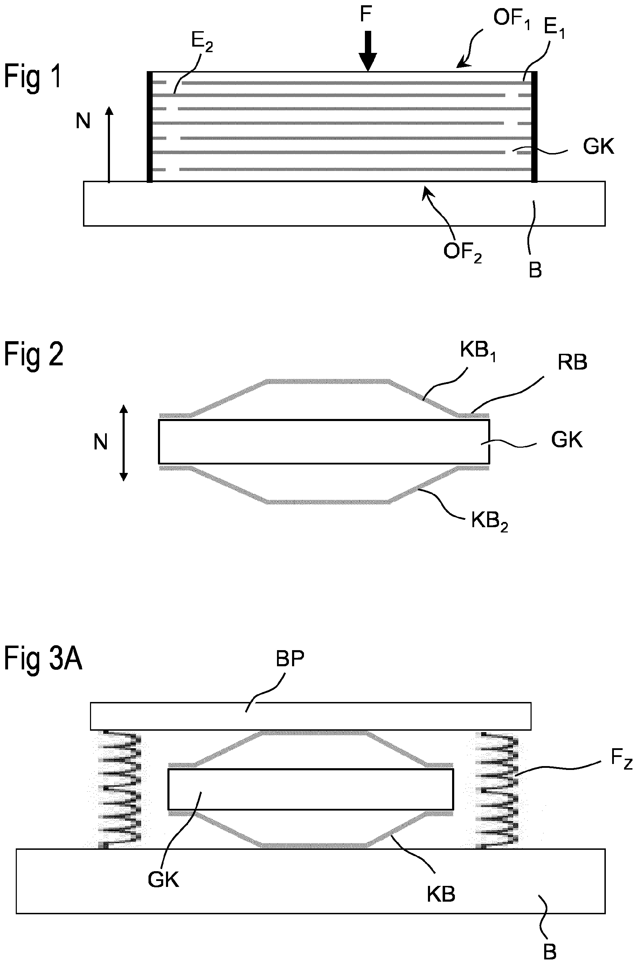

Figur 1 zeigt einen einfachen piezoelektrischen Grundkörper GK mit einer ersten und einer zweiten Aktorelektrode E1, E2. Der Grundkörper GK ist beispielsweise in Form von Übereinanderstapeln von piezoelektrischen Schichten erzeugt, die jeweils mit Elektrodenmaterial bedruckt sind oder werden.

Die Schichten werden vorzugsweise als keramische Grünfolien eingesetzt und mit einer einbrennbaren Elektrodenpaste für die Aktorelektroden bedruckt. Nach Übereinanderstapeln einer gewünschten Menge an Schichten werden diese abschließend gemeinsam zu einem monolithischen Block - dem Grundkörper - gesintert. Der Aktor (= Grundkörper mit Aktorelektroden) umfasst eine Piezokeramik, beispielsweise auf der Basis von PZT (Bleizirkonat-Titanat). Die PZT-Keramik kann ferner zusätzlich Nd und Ni enthalten. Alternativ kann die PZT-Keramik ferner zusätzlich Nd, K und gegebenenfalls Cu aufweisen. Alternativ können die piezoelektrischen Schichten eine Pb(ZrₓTi₁₋ₓ)O₃ + y Pb(Mn_{1/3}Nb_{2/3})O₃ enthaltenden Zusammensetzung aufweisen. Die piezoelektrischen Schichten können so polarisiert sein, dass durch das Anlegen einer Wechselspannung zwischen den ersten und den zweiten Innenelektroden und dem damit verbundenen piezoelektrischen Effekt, die Längenänderung des Grundkörpers hervorgerufen wird.

Der Grundkörper ist auf einer Basis B angeordnet, die beispielsweise eine Oberfläche eines elektrischen Bauelements bildet. Die Stapelrichtung der einzelnen Schichten entspricht der Oberflächennormalen N des Grundkörpers. Die auf dem Piezoaktor ausgeübte Kraft F wirkt mit ihrem vertikal zur Oberfläche beziehungsweise parallel zur Normalen N wirkenden Anteil. Nur diese Kraft wird in eine elektrische Spannung umgesetzt, die an den Aktorelektroden E1, E2 abgreifbar ist, beziehungsweise an Messelektroden, die in der Figur nicht dargestellt sind.

Zum Erzeugen des haptischen Feedbacks wird zwischen erster Aktorelektrode E1 und zweiter Aktorelektrode E2 eine Aktorspannung angelegt, die zu einer Längenänderung des Grundkörpers GK führt. Durch entsprechende Polung des piezoelektrischen Grundkörpers kann die dadurch bewirkte Längenänderung parallel zur Normalen erfolgen, also gegenläufig zur ausgeübten Kraft F, so dass sie von einem Nutzer am besten wahrgenommen werden kann.

Figur 2 zeigt anhand eines schematischen Querschnitts, wie die Längenausdehnung der gesamten Vorrichtung in Richtung der Normalen verstärkt werden kann. Auf beiden Hauptoberflächen des Grundkörpers GK ist jeweils ein kegelstumpfförmiges Blech KB1, KB2 montiert. Dazu ist ein flach ausgeführter Randbereich, der flach auf der Hauptoberfläche des Grundkörpers GK aufliegen kann, fest mit diesem verbunden. Der Randbereich kann beispielsweise mittels Kleben, Löten oder Schweißen an dem Grundkörper befestigt sein. Durch die besondere Ausformung, insbesondere durch die Mantelflächen und die Deckfläche des Kegelstumpfs, wird eine Querkontraktion des Grundkörpers GK direkt in eine Verformung des Bleches umgesetzt, die parallel zur Normalen N verläuft.

Das Blech kann als Material Titan umfassen oder aus Titan bestehen. Titan weist insbesondere für die hier vorliegende Anwendung der Vorrichtung zur Erzeugung eines aktiven haptischen Feedbacks wesentliche Vorteile auf. Außerdem weist Titan einen thermischen Ausdehnungskoeffizienten auf, der sehr nahe an dem thermischen Ausdehnungskoeffizienten des Grundkörpers liegt. Dadurch wird die Verbindungsstelle des Blechs mit dem Grundkörper bei einer Veränderung der Temperatur nicht wesentlich mechanisch belastet. Beispielsweise können sowohl das Blech als auch der Grundkörper einen thermischen Ausdehnungskoeffizienten zwischen 8 und 9 ppm/K aufweisen.

Figur 3A zeigt eine Ausführungsform der erfindungsgemäßen Vorrichtung, bei der der Piezoaktor beziehungsweise der Grundkörper GK mit den beiden kegelstumpfförmigen Blechen KB1, KB2 zwischen der Basis B und einer Betätigungsplatte BP fixiert ist. Die Fixierung erfolgt durch Spiralfedern F_{z}, mit deren Hilfe die Betätigungsplatte BP in Richtung Basis B gezogen wird und so den Grundkörper GK fixiert. Auf diese Weise kann sich der keramische Grundkörper ungehindert bewegen und eine starre Befestigung der Keramik des Grundkörpers an der Basis oder an eine zu bewegende Fläche kann entfallen. Dies gestattet es, das Übersetzungsvermögen der beiden kegelstumpfförmigen Bleche voll auszunutzen und mindert dabei gleichzeitig das Risiko, die Keramik beziehungsweise den Grundkörper zu beschädigen. Durch die Verspannung über die Federn FZ ist stets ein direkter Kontakt der kegelstumpfförmigen Bleche mit der Betätigungsplatte beziehungsweise mit der Basis gewährleistet und über die Lebensdauer und die Betriebsbedingungen, bei der die Vorrichtung betrieben wird, sichergestellt.

Die Betätigungsplatte BP ist beispielsweise rechteckig und aus Aluminium ausgebildet. Sie weist eine für die einwirkenden Kräfte ausreichende mechanische Stabilität bzw. Dicke auf. Sie kann aber auch aus anderen Materialien ausgebildet sein, z.B. aus Metall, Kunststoff, Keramik, Glas oder Holz. Dabei ist sie so ausgebildet, dass das haptische Feedback möglichst störungsfrei bzw. ohne Dämpfung übertragen werden kann. Dies setzt ein Material mit einer gewissen Härte bzw. einem hohen E-Modul voraus.

Die Betätigungsplatte BP weist eine größere Grundfläche als der Grundkörper GK auf und steht vorzugsweise allseitig über dessen Rand über. Eine sichere Fixierung wird mit zumindest zwei Federn F_{Z} erreicht. Vorteilhaft ist es jedoch, eine höhere Anzahl von Federn F_{Z} einzusetzen, um eine symmetrische Verspannung zu ermöglichen. Die Federn F_{Z} sind dann gleichmäßig über den Umfang der Betätigungsplatte verteilt.

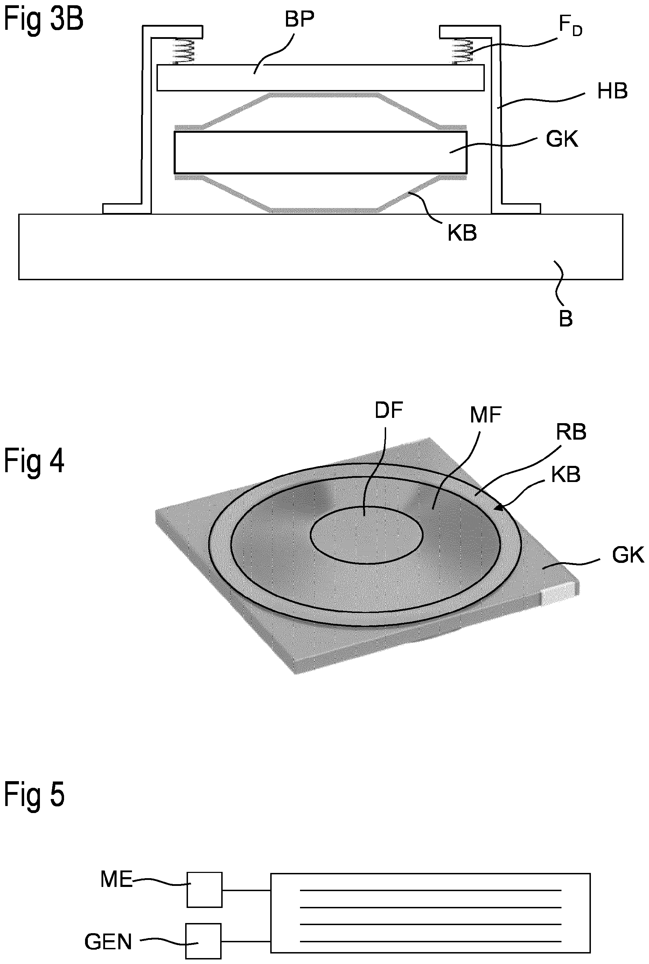

Ähnliche Vorteile wie mit der Ausführungsform nach Figur 3A werden mit einer weiteren Ausführungsform gemäß Figur 3B erzielt. In dieser Ausführungsform wird der Grundkörper GK mit den beiden kegelstumpfförmigen Blechen KB ebenfalls zwischen der Betätigungsplatte BP und der Basis B unter Druck fixiert, wobei mit Hilfe von Spiralfedern F_{D} der Druck zum Fixieren jedoch von oben auf die Betätigungsplatte BP einwirkt. Die Spiralfedern F_{D} sind unter Druckspannung zwischen der Betätigungsplatte und Haltebügeln HB eingespannt. Die Haltebügel HB ragen über die Betätigungsplatte BP und bilden dort einen Ansatzpunkt für die Federn F_{D}.

In der Figur 3B ist der Bügel im Querschnitt dargestellt. Pro Feder kann ein einzelner Haltebügel eingesetzt werden. Vorteilhaft ist es jedoch, eine Bügelleiste zu verwenden, die einen in der Figur 3B dargestellten oder ähnlichen Querschnitt aufweist, an der mehrere Federn F_{D} angreifen können.

Noch besser ist es, wenn die Schiene, die im Querschnitt den Haltebügel HB bildet, rund um die Betätigungsplatte umläuft, so dass die Betätigungsplatte quasi wie in einer Hülse bei offenem Haltebügel gehalten wird. Diese Ausführung hat den Vorteil, dass selbst bei starker Auslenkung immer noch ein sicherer Halt gewährleistet ist. Während die unter Zugspannung stehenden Federn F_{Z} der Ausführung gemäß Figur 3A gegebenenfalls überdehnt werden können, was zu einer schwächeren oder nachlassenden Fixierung führt, ist mit der Ausführung nach Figur 3B über den Haltebügel HB ein Anschlag vorgesehen, der ein zu starkes Ausweichen der Betätigungsplatte BP nach oben verhindert.

Figur 4 zeigt eine dreidimensionale Darstellung einer erfindungsgemäßen Vorrichtung in schräger Draufsicht. Der Grundkörper GK weist vorteilhaft eine quadratische Grundfläche auf, während das kegelstumpfförmige Blech KB eine runde Grundfläche aufweist, die mit ihrem Randbereich zentral auf der Oberfläche des Grundkörpers GK befestigt ist. Im Bereich der Mantelfläche MF verläuft das kegelstumpfförmige Blech nach oben und verjüngt sich radial, so dass die Deckfläche DF ebenfalls eine runde Grundfläche aufweist. Die Deckfläche DF kann plan sein, kann aber eine fingerförmige in Richtung Grundkörper weisende Vertiefung aufweisen, um sich der Fingerform eines Nutzers anzupassen.

Figur 5 zeigt einen Grundkörper GK im schematischen Querschnitt. Dargestellt sind die Aktorelektroden E1, E2, die als Innenelektroden parallel zueinander und parallel zu den Hauptoberflächen des Grundkörpers in gleichem Abstand zueinander ausgerichtet sind. Nicht dargestellt ist eine spezielle Messelektrode, die einen größeren Abstand zur benachbarten Aktorelektrode aufweisen kann. Ebenfalls nicht dargestellt ist die Verbindung der Aktorelektroden mit Außenkontakten, über die die Aktorelektroden parallel verschaltet sein können. Dazu können die Innenelektroden stegförmig bis zum Rand des Grundkörpers verlängert sein und dort einen der beiden Anschlusskontakt kontaktieren. Dieses Herausführen der Innenelektroden zu den Kanten des Grundkörpers GK erfolgt alternierend für erste und zweite Aktorelektrode hin zu unterschiedlichen Anschlusskontakten, so dass über insgesamt zwei Anschlusskontakte sämtliche erste und zweite Aktorelektroden kontaktiert werden können.

Zumindest zwei der Innenelektroden des Grundkörpers sind mit einer Messeinheit ME verbunden, die eine elektrische Spannung erkennen kann, die durch Ausüben einer Kraft vertikal auf eine Hauptoberfläche des Grundkörpers einwirkt und durch den inversen piezoelektrischen Effekt in der piezoelektrischen Keramik erzeugt wird. Ein Spannungsgenerator GEN ist mit den beiden Außenkontakten von ersten und zweiten Aktorelektroden E1, E2 verbunden. Wird von der Messeinheit ME das Erreichen einer Auslösekraft erkannt, die sich im Überschreiten der erzeugten Messspannung manifestiert, wird vom Spannungsgenerator GEN eine Aktorspannung erzeugt und an erste und zweite Aktorelektroden angelegt. Diese wiederum führen zur Auslenkung des Grundkörpers, der als haptisches Feedback vom Nutzer erkannt wird.

Um die Wahrnehmung zu verstärken, kann die an die Aktorelektroden angelegte Spannung in Form verschiedener, aufeinander folgender Pulse moduliert werden. Deren Abfolgefrequenz wird dann so gewählt, dass das Feedback als eine Vibration vom Nutzer wahrnehmbar ist. Möglich ist es auch, an die Aktorelektroden eine Wechselspannung geeigneter Frequenz anzulegen. Weiterhin ist es möglich, dass in der Messeinheit und der damit verbundenen Steuereinheit mehrere Schwellwerte definiert sind, die in der Folge unterschiedliche Feedbacks erzeugen können. Unterschiedliche Feedbacks können sich in der Frequenz oder allgemein in der Länge, Abfolgefrequenz oder Anzahl der Pulse unterscheiden. Parallel dazu kann die Vorrichtung dann abhängig von dem erreichten Schwellwert unterschiedliche Aktionen auslösen.

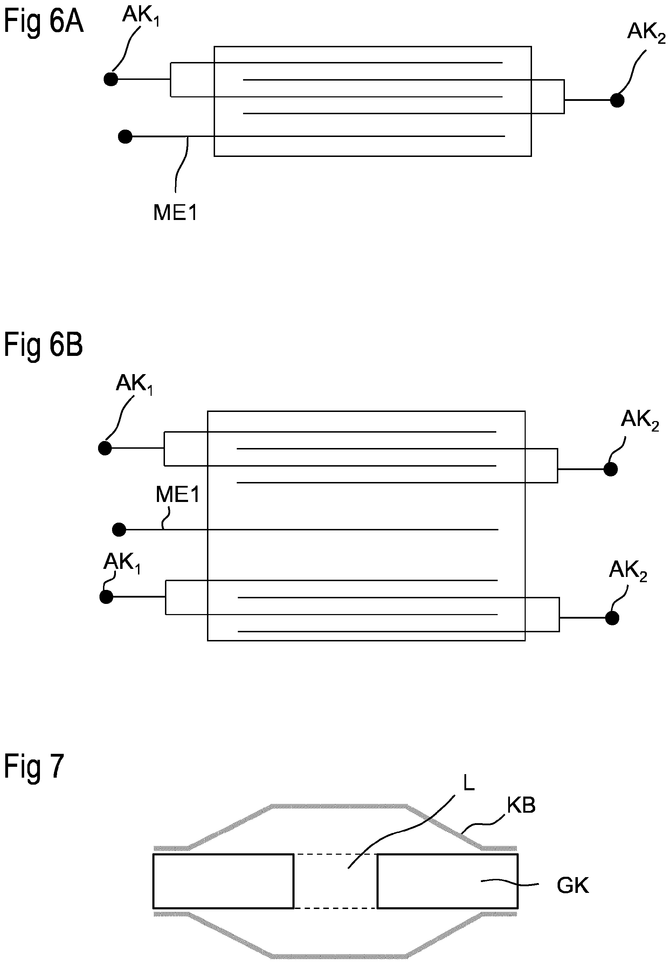

Figur 6A zeigt eine mögliche Anordnung der Messelektrode ME im Grundkörper GK so, dass alle Aktorelektroden auf einer Seite der Messelektrode angeordnet sind. Die Messelektrode kann dann in der Nähe einer Hauptoberfläche des Grundkörpers angeordnet sein.

Figur 6B zeigt anhand eines schematischen Querschnitts, wie die Messelektrode in der Mitte des Grundkörpers zwischen den Aktorelektroden E1, E2 angeordnet ist. Zwischen Messelektrode ME und Aktorelektroden E kann ein größerer Abstand vorgesehen sein als zwischen Aktorelektroden unterschiedlicher Polarität. Die ersten Aktorelektroden E1 sind mit einem ersten Außenkontakt Ak1, die zweiten Aktorelektroden E2 mit einem zweiten Außenkontakt AK2 verbunden.

Figur 7 zeigt eine weitere Ausführungsform der Erfindung, bei der keramische Grundkörper, also das piezoelektrische Material des Grundkörpers in der Mitte durchbrochen ist, vorzugsweise in Form eines durchgehenden zylinderförmigen Loches L. Der Randbereich des kegelstumpfförmigen Bleches KB ist in ausreichendem Abstand zu den Rändern des Loches an den Hauptoberflächen des Grundkörpers befestigt. Das Loch hat den Vorteil, dass es die sich zwischen den Aktorelektroden aufbauende Kapazität des piezoelektrischen Aktors reduziert und so die Funktion des Aktors mit geringerer Leistung bei unverändert hoher Längenausdehnung möglich wird.

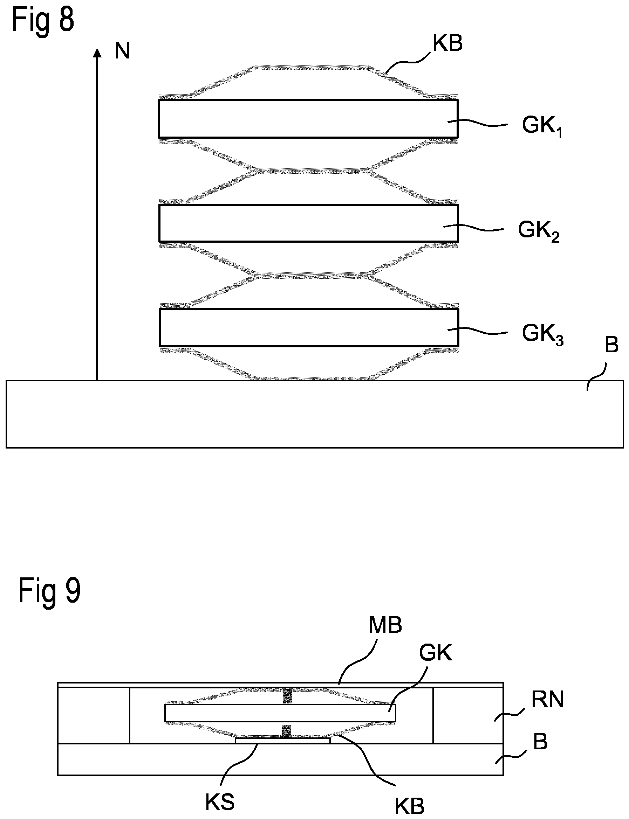

Figur 8 zeigt eine weitere Ausführungsform, bei der mehrere Vorrichtungen, umfassend jeweils mit zwei kegelstumpfförmigen Blechen KB versehene Grundkörper GK vertikal übereinander gestapelt sind, so dass die Seitenkanten sämtlicher Grundkörper miteinander fluchten, sich die Grundflächen also zu 100 Prozent überdecken. Obwohl nicht dargestellt, ist es in dieser Ausführungsform besonders vorteilhaft, eine Fixierung dieser übereinander gestapelten Vorrichtungen mit Hilfe einer Betätigungsplatte und mit Spiralfedern gegen die Basis B zu fixieren, auf der der Stapel aufliegt. Vorteilhaft ist es hier, die Grundkörper auch seitlich über Haltebügel zu fixieren, beziehungsweise deren seitliches Verrutschen durch entsprechend nahestehende Haltebügel oder andere Anschläge zu begrenzen. Auch auf diese Weise wird gewährleistet, dass die Grundkörper maximal beweglich sind, dass die Längenausdehnung nicht gehindert ist und dass sich die Längenausdehnung der einzelnen Vorrichtungen additiv zu einer Gesamtauslenkung parallel zur Normalen N vertikal über der Oberfläche der Basis B addieren.

Figur 9 zeigt ein weiters Ausführungsbeispiel einer erfindungsgemäßen Vorrichtung, die einen Grundkörper GK aufweist. Über der oberen Zymbel KB ist eine Membran MB verspannt. Diese ist dünn und flexibel ausgeführt. Durch diese Verspannung und die Elastizität übt die Membran eine gegen die Basis B wirkende Kraft aus, die einer Federkraft entspricht. Die Membran MB stellt die für den Benutzer sichtbare und bedienbare Oberfläche dar. Dies hat den Vorteil, dass die Bedienoberfläche spaltenlos ist.

Membran MB und Basis B sind fest miteinander verbunden. Dies kann z.B. durch eine Verschraubung erfolgen (in der Figur nicht dargestellt). Die Membran kann auch über einen Rahmen RN gespannt sein, der auf der Basis B fixiert ist. Damit wird eine ebene Bedienoberfläche erhalten. Gleichzeitig garantiert die dünne Membran MB, dass das haptische Feedback durch die Membran nicht abgeschwächt wird. Die Basis ist dagegen ist als steifer Körper ausgebildet.

Der gezeigte Aufbau stellt sicher, dass bei Betätigung der Vorrichtung die Membran MB verformt wird und damit die Stärke der haptischen Rückmeldung für den Benutzer maximiert wird. Zusätzlich kann die Federwirkung der Membran durch Variation der Dicke oder der Verbindung zwischen Membran MB und Basis B optimiert werden.

Die Membran ist vorteilhaft so ausgebildet, dass sie eine Steifigkeit aufweist, die im Bereich von 1% - 50% der Steifigkeit des Aktors liegt.

Um ein Verrutschen des Aktors im Betrieb zu verhindern, kann dieser zusätzlich an Rückwand (und/oder Membran) befestigt werden. Eine mögliche Befestigungsweise ist die Fixierung des Aktors mittels einer Klebeschicht KS.

Neben den insbesondere in den Figuren 4 und 7 dargestellten Ausführungsformen mit einem Grundkörper rechteckiger oder quadratischer Grundfläche ist es auch möglich, den Grundkörper mit runder Grundfläche auszuführen. Die quadratische oder rechteckige Ausführung hat lediglich verfahrenstechnische Vorteile, wenn der Grundkörper aus einem großflächigeren Stapel herausgeschnitten wird, was mit geraden Schnitten erfolgt, die zu rechteckigen oder quadratischen Grundkörpern führen. Dem entsprechend kann ein Grundkörper eine Seitenlänge zwischen 10 und 30 mm aufweisen, die auch den Abmessungen eines rund ausgeführten Grundkörpers entsprechen kann. Der Grundkörper kann in Richtung der Normalen eine Höhe zwischen 0,5 und 2 mm aufweisen. Das kegelstumpfförmige Blech KB kann so dimensioniert werden, dass der Abstand zwischen dem mittleren Bereich der Deckfläche DF und der Oberfläche des Grundkörpers ca. 0,5 mm beträgt, wenn keine Kraft auf das Bauelement ausgeübt wird und wenn keine Spannung zwischen ersten und zweiten Aktorelektroden anliegt.

Vorzugsweise ist der Aufbau der Vorrichtung symmetrisch, so dass oberes und unteres kegelstumpfförmiges Blech symmetrisch zueinander in ihren Abmessungen und Anordnungen sind. Das kegelstumpfförmige Blech KB weist eine maximale Ausdehnung relativ zur Grundfläche des Grundkörpers auf, so dass innerhalb des Randbereichs, der auf der Hauptoberfläche des Grundkörpers aufliegt, ein maximalen Flächeninhalt umschlossen wird. Dann ist auch das zwischen den beiden Blechen angeordnete Aktorvolumen maximal. Auf diese Weise gelingt es, eine Querkontraktion maximal zu erfassen beziehungsweise in maximaler Stärke in die gewünschte Auslenkung umzuwandeln.

Die Erfindung konnte nur anhand weniger Ausführungsbeispiele dargestellt werden und ist daher nicht auf die genaue Ausführung entsprechend der Ausführungsbeispiele beschränkt. Im Rahmen der Erfindung liegt es, die Anzahl der Aktorelektroden, die Anzahl der Anschlusskontakte oder die Anzahl übereinander gestapelter Grundkörper beliebig zu variieren. Die Ausformung der Grundfläche ist in erster Näherung auch ohne Relevanz auf die Wirksamkeit der Vorrichtung. Das haptische Feedback kann in gewünschter Weise realisiert und die Auslenkung entsprechend moduliert werden. Weiterhin kann die Auslösekraft nahezu beliebig eingestellt werden, so dass entweder nur eine leichte Berührung bis hin zu einem festen Druck zum Erreichen der gewünschten Auslösekraft erforderlich sein kann.

### Bezugszeichenliste

- AA: Aktorauslenkung
- AK: Außenkontakt
- B: Basis
- BP: Betätigungsplatte
- DF: stumpfe Kegelspitze = Deckfläche
- E1, E2: erste und zweite Aktorelektrode
- F: auf den Aktor ausgeübte Kraft
- F_{D}, F_{S}: Feder mit Druck- oder Zugvorspannung
- GEN: Spannungsgerators
- GK: piezoelektrischer Grundkörper
- HB: Haltebügel
- KB: kegelstumpfförmiges Blech
- L: Loch im Grundkörper
- MB: Membran
- ME: Messeinheit
- ME1, ME2: erste und zweite Messelektrode
- MF: Mantelfläche des Blechs
- N: Normale zur Hauptoberfläche
- OF₁, OF₂: Hauptoberflächen des Grundkörpers
- RB: Randbereich des Blechs

## Patentansprüche

1. Vorrichtung zur Erzeugung eines aktiven haptischen Feedbacks,
aufweisend einen piezoelektrischen Aktor, der einen flachen piezoelektrischen Grundkörper (GK) mit planparallelen Hauptoberflächen (DF) sowie ersten und zweiten Aktorelektroden, (E₁,E₂) umfasst,
wobei der Grundkörper ausgestaltet ist, ein aktives haptisches Feedback zu erzeugen, wenn eine auf den Grundkörper ausgeübte Kraft erkannt wird,
wobei das haptische Feedback dadurch erzeugt wird, dass zwischen den ersten und zweiten Aktorelektroden eine elektrische Aktorspannung angelegt wird, die mittels piezoelektrischer Aktorwirkung zu einer Längenänderung des Grundkörpers entlang einer Normalen zu einer der Hauptoberflächen führt
wobei auf jeder der beiden Hauptoberflächen des Grundkörpers ein kegelstumpfförmiges Blech (KB) - Zymbel - so befestigt ist, dass die stumpfe Kegelspitze jeweils vom Grundkörper (GK) wegweist
wobei der Grundkörper mit den stumpfen Kegelspitzen zwischen einer Basis (B) und einem Betätigungsmittel (BP,MB) fixiert ist, wobei das Betätigungsmittel mit der Basis in Verbindung steht und mittels einer Vorspannung daran fixiert ist, die als Zug- oder Druckspannung eingestellt ist, dadurch gekennzeichet, dass im Grundkörper eine Messelektrode (ME1) angeordnet ist
wobei eine Messeinheit (ME) vorgesehen ist zur Messung einer zwischen der Messelektrode und einer der Aktorelektroden erzeugten Messspannung, die in Folge einer auf den Grundkörper (GK) ausgeübten Kraft entsteht, und
wobei das Bauelement dazu ausgestaltet ist, diese ausgeübte Kraft zu erkennen, sobald die von der Messeinheit (ME) erfasste Messspannung einen Schwellwert übersteigt, der einer Auslösekraft zugeordnet ist
wobei bei Erreichen der Auslösekraft mittels eines Spannungsgerators eine Aktorspannung erzeugt und an die Aktorelektroden angelegt wird und dabei gleichzeitig eine weitere Aktion ausgelöst wird, die zum Betrieb der Vorrichtung oder eines damit verbundenen elektrischen Bauelements dient.

2. Vorrichtung gemäß Anspruch 1,
bei der das Betätigungsmittel als Betätigungsplatte (BP) ausgebildet ist.

3. Vorrichtung gemäß Anspruch 1 oder 2,
wobei das kegelstumpfförmige Blech (KB) einen Randbereich (RB) aufweist, der auf jeweils einer der Hauptoberflächen des Grundkörpers (GK) befestigt ist,
wobei das kegelstumpfförmige Blech eine Mantelfläche (MF) aufweist, die in Richtung der Normalen über der jeweiligen Hauptoberfläche absteht
wobei das kegelstumpfförmige Blech an der stumpfen Kegelspitze eine Deckfläche (DF) aufweist, die parallel zur Oberfläche des Grundkörpers (GK) ausgerichtet ist oder die eine anatomisch angepasste Fingermulde aufweist.

4. Vorrichtung gemäß einem der vorherigen Ansprüche,
bei der die Aktorelektroden gleichzeitig auch die Messelektroden darstellen,
bei der die Messeinheit zur Bestimmung der Messspannung zwischen den beiden Aktorelektroden ausgebildet ist.

5. Vorrichtung gemäß einem der vorherigen Ansprüche,
wobei eine von den Aktorelektroden verschiedene Messelektrode entweder mittig im Grundkörper zwischen ersten und zweiten Aktorelektroden oder in der Nähe einer der Hauptoberflächen angeordnet ist, sodass alle ersten und zweiten Aktorelektroden auf einer Seite der Messelektrode angeordnet sind.

6. Vorrichtung gemäß einem der vorherigen Ansprüche,
wobei der Grundkörper ein durchgehendes Loch aufweist, das sich parallel zur Normalen zwischen den beiden Hauptoberflächen erstreckt.

7. Vorrichtung gemäß einem der vorherigen Ansprüche,
wobei die Hauptoberflächen rund sind.

8. Vorrichtung gemäß einem der vorherigen Ansprüche,
wobei der Grundkörper eine Grundfläche aufweist, deren Seitenlängen zwischen 9 und 30 mm liegen.

9. Vorrichtung gemäß einem der vorherigen Ansprüche,
wobei der Grundkörper zwischen den beiden Hauptoberflächen eine Höhe zwischen 0,5 und 2,0 mm aufweist.

10. Vorrichtung gemäß einem der Ansprüche 2 bis 9,
wobei die Betätigungsplatte eine größere Grundfläche als der Grundkörper aufweist.

11. Vorrichtung, aufweisend mehrere übereinander gestapelte Vorrichtungen gemäß einem der vorherigen Ansprüche.

12. Vorrichtung gemäß einem der vorherigen Ansprüche, ausgebildet als Betätigungsknopf eines elektrischen Bauelements.

13. Vorrichtung gemäß einem der vorherigen Ansprüche,
bei der über der nach außen weisende Zymbel als Betätigungsmittel eine Membran (MB) verspannt ist, die die Zymbeln (KB) und damit auch den Aktor mit einer in Richtung einer Basis (BS) wirkenden Vorspannung an der Basis fixiert.

## Claims

1. Device for generating active haptic feedback, having a piezoelectric actuator which comprises a flat piezoelectric base body (GK) with plane-parallel main surfaces (DF) as well as first and second actuator electrodes (E₁, E₂),
wherein the base body is configured to generate active haptic feedback if a force which is applied to the base body is detected,
wherein the haptic feedback is generated by virtue of the fact that an electrical actuator voltage is applied between the first and second actuator electrodes, said volage bringing about, by means of a piezoelectric actuator effect, a change in length of the base body along a line which is perpendicular to one of the main surfaces,
wherein a truncated-cone-shaped piece of sheet metal (KB) - cymbal- is attached to each of the two main surfaces of the base body in such a way that the obtuse tip of the cone points away from the base body (GK) in each case,
wherein the base body with the obtuse tips of the cone is secured between a base (B) and an activation means (BP, MB), wherein the activation means is connected to the base and is secured thereto by means of a prestress which is set as a tensile stress or compressive stress,
**characterized in that** a measuring electrode (ME1) is arranged in the base body, wherein a measuring unit (ME) is provided for measuring a measuring volage which is generated between the measuring electrode and one of the actuator electrodes and arises owing to a force which is applied to the base body (GK), and
wherein the component is configured to detect this applied force as soon as the measuring voltage which is sensed by the measuring unit (ME) exceeds a threshold value which is assigned to a triggering force, wherein when the triggering force is reached by means of a voltage generator an actuator voltage is generated and applied to the actuator electrodes, and at the same time a further action is triggered which serves to operate the device or an electrical component which is connected thereto.

2. Device according to Claim 1,
in which the actuation means is embodied as an actuation plate (BP).

3. Device according to Claim 1 or 2,
wherein the truncated cone-shaped piece of sheet metal (KB) has an edge region (RB) which is attached to in each case one of the main surfaces of the base body (GK), wherein the truncated-cone-shaped piece of sheet metal has a lateral face (MF) which protrudes beyond the respective main surface in the direction of the perpendicular line,
wherein the truncated-cone-shaped piece of sheet metal has, at the obtuse tip of the cone, a cover face (DF) which is oriented parallel to the surface of the base body (GK) or which has an anatomically adapted finger depression.

4. Device according to one of the preceding claims, in which the actuator electrodes at the same time also constitute the measuring electrodes,
and in which the measuring unit is designed to determine the measurement voltage between the two actuator electrodes.

5. Device according to one of the preceding claims,
wherein a measuring electrode which is different from the actuator electrodes is either arranged centrally in the base body between first and second actuator electrodes or in the vicinity of one of the main surfaces so that all the first and second actuator electrodes are arranged on one side of the measuring electrode.

6. Device according to one of the preceding claims,
wherein the base body has a continuous hole which extends parallel to the perpendicular line between the two main surfaces.

7. Device according to one of the preceding claims,
wherein the main surfaces are round.

8. Device according to one of the preceding claims,
wherein the base body has a base face whose side lengths are between 9 and 30 mm.

9. Device according to one of the preceding claims,
wherein the base body has a height between 0.5 and 2.0 mm between the two main surfaces.

10. Device according to one of Claims 2 to 9, wherein the actuation plate has a larger base face than the base body.

11. Device having a plurality of devices according to one of the preceding claims, which are stacked one on top of the other.

12. Device according to one of the preceding claims, embodied as an actuation knob of an electrical component.

13. Device according to one of the preceding claims, in which a diaphragm (MB) is stretched over the outwardly pointing cymbal as an actuation means, which device secures the cymbals (KB) and therefore also the actuator to a base (BS) with prestress acting in the direction of the base.

## Revendications

1. Dispositif de génération d'un retour haptique actif, comportant
un actionneur piézoélectrique qui comprend un corps de base piézoélectrique plat (GK) pourvu de surfaces principales planes parallèles (DF) et de première et deuxième électrodes d'actionneur (E₁, E₂),
le corps principal étant conçu pour générer un retour haptique actif lorsqu'une force exercée sur le corps principal est détectée,
le retour haptique étant généré par application d'une tension d'actionneur électrique entre les première et deuxième électrodes d'actionneur, ce qui entraîne une variation de longueur du corps de base le long d'une normale à l'une des surfaces principales par un effet piézoélectrique de l'actionneur,
une tôle tronconique (KB) - coupelle - étant fixée à chacune des deux surfaces principales du corps de base de telle sorte que la pointe du cône tronqué est dirigée à l'opposé du corps de base (GK),
le corps de base avec les pointes tronconiques étant fixé entre une base (B) et un moyen d'actionnement (BP, MB), le moyen d'actionnement étant relié à la base et étant fixé à celle-ci au moyen d'une précontrainte qui est définie comme une contrainte de traction ou de compression,
**caractérisé en ce que**
une électrode de mesure (ME1) est disposée dans le corps de base,
une unité de mesure (ME) étant prévue pour mesurer une tension de mesure qui est générée entre l'électrode de mesure et l'une des électrodes d'actionneur et qui résulte d'une force exercée sur le corps de base (GK), et
le composant étant conçu pour détecter cette force exercée dès que la tension de mesure détectée par l'unité de mesure (ME) dépasse une valeur seuil qui est associée à une force de déclenchement,
lorsque la force de déclenchement est atteinte, une tension d'actionneur étant générée au moyen d'un générateur de tension et étant appliquée aux électrodes d'actionneur et en même temps une autre action étant déclenchée qui est utilisée pour faire fonctionner le dispositif ou un composant électrique relié à celui-ci.

2. Dispositif selon la revendication 1,
le moyen d'actionnement étant conçu sous la forme d'une plaque d'actionnement (BP).

3. Dispositif selon la revendication 1 ou 2,
la tôle tronconique (KB) comportant une zone de bord (RB) qui est fixée à l'une des surfaces principales du corps de base (GK),
la tôle tronconique comportant une surface d'enveloppe (MF) qui fait saillie de la surface principale respective dans la direction de la normale,
la tôle tronconique comportant au niveau de la pointe du cône tronqué une surface supérieure (DF) qui est orientée parallèlement à la surface du corps de base (GK) ou qui comporte un évidement de doigt anatomiquement adapté.

4. Dispositif selon l'une des revendications précédentes, dans lequel
les électrodes d'actionnement représentent également en même temps les électrodes de mesure,
l'unité de mesure est conçue pour déterminer la tension de mesure entre les deux électrodes d'actionnement.

5. Dispositif selon l'une des revendications précédentes,
une électrode de mesure différente des électrodes d'actionnement étant disposée soit au centre dans le corps de base entre des première et deuxième électrodes d'actionnement, soit à proximité de l'une des surfaces principales de sorte que toutes les première et deuxième électrodes d'actionnement soient disposées sur un côté de l'électrode de mesure.

6. Dispositif selon l'une des revendications précédentes,
le corps de base comportant un trou traversant qui s'étend parallèlement à la normale entre les deux surfaces principales.

7. Dispositif selon l'une des revendications précédentes,
les surfaces principales étant rondes.

8. Dispositif selon l'une des revendications précédentes,
le corps de base comportant une surface de base dont les longueurs latérales sont comprises entre 9 et 30 mm.

9. Dispositif selon l'une des revendications précédentes,
le corps de base ayant entre les deux surfaces principales une hauteur comprise entre 0,5 et 2,0 mm.

10. Dispositif selon l'une des revendications 2 à 9,
la plaque d'actionnement ayant une surface de base plus grande que celle du corps de base.

11. Dispositif comportant une pluralité de dispositifs selon l'une des revendications précédentes qui sont empilés les uns sur les autres.

12. Dispositif selon l'une des revendications précédentes, conçu sous la forme d'un bouton d'actionnement d'un composant électrique.

13. Dispositif selon l'une des revendications précédentes, dans lequel une membrane (MB) est tendue comme moyen d'actionnement par-dessus la coupelle dirigée vers l'extérieur et fixe, avec une précontrainte agissant en direction d'une base (BS), la coupelle (KB) et donc également l'actionneur à la base.
